# EUROPÄISCHE PATENTSCHRIFT

(11) **EP 0 906 010 B1**
(45) Veröffentlichungstag und Bekanntmachung des Hinweises auf die Patenterteilung: **06.04.2005**
(21) Anmeldenummer: 98116620.0
(22) Anmeldetag: 02.09.1998
(51) Int. Cl.: H05K 13/04

(54) **Vorrichtung zum Bestücken von Bauelementeträgern mit elektrischen Bauelementen**
Apparatus for mounting of electrical components on component carriers
Dispositif pour le montage de composants électriques sur des supports de composants

(30) Priorität: 30.09.1997 DE 19743237
(43) Veröffentlichungstag der Anmeldung: 31.03.1999
(73) Patentinhaber: SIEMENS AKTIENGESELLSCHAFT, 80333 München (DE)
(72) Erfinder: Wacker, Josef, 82335 Berg (DE)

(56) Entgegenhaltungen:
- WO-A-96/01036
- WO-A-97/37522
- DE-U- 9 407 004

## Beschreibung

Die Erfindung bezieht sich auf eine Vorrichtung zum Bestücken von Bauelementeträgern mit elektrischen Bauelementen mittels eines revolverartigen Bestückkopfes mit einem stationären Teil und einem daran drehbar gelagerten Drehkörper, an dem eine Vielzahl von Sauggreifern zirkulär angeordnet ist.

Eine derartige Vorrichtung ist z.B. durch das deutsche Gebrauchsmuster G 94 07 004 bekannt geworden. Dabei wird nach dem Aufsetzen des Bauelementes auf den Bauelementeträger die im Greifer wirkende Saugluft kurzzeitig auf Blasluft umgeschaltet. Dies wird dadurch erreicht, daß jedem der Sauggreifer ein im Drehkörper gelagertes Ventil zugeordnet ist, das in der Aufsetzstellung umgeschaltet werden kann.

Ferner ist es durch die WO 96/01036 bekannt, den für das Saugen erforderlichen Unterdruck durch eine Strahlpumpe zu erzeugen. Es ist üblich, eine solche Strahlpumpe im Drehkörper des Bestückkopfes zentral anzuordnen. Dies hat den Vorteil, daß nur eine Pneumatikleitung zum Drehkörper geführt werden muß. Die von der Strahlpumpe erzeugte Saugluft wird über Leitungen den einzelnen Saugpipetten zugeführt, wobei die Blasluft durch einen überlagernden Druckluftimpuls erzeugt wird, der durch ein der jeweiligen Saugpipette zugeordnetes Ventil freigegeben wird.

Der Erfindung liegt die Aufgabe zugrunde, die Bestückvorrichtung hinsichtlich der pneumatischen Funktion zu vereinfachen und zu verbessern.

Diese Aufgabe wird durch die Erfindung gemäß Anspruch 1 gelöst. Durch die Zuordnung je einer Strahlpumpe zu den Sauggreifern ist es möglich, die Saugluft in unmittelbarer Nähe der Sauggreifer zu erzeugen, wodurch das zu ändernde Luftvolumen verkleinert wird. Dadurch können die Umschaltzeiten zwischen Saugluft und Druckluft minimiert werden, so daß die Aufsetzzeit verringert werden kann. Die im Nebenstromkanal benötigten Druckunterschiede werden durch die Beeinflussung des Hauptstromes erzeugt, so daß keine Ventile benötigt werden. Die Beeinflussungsvorrichtung kann dem stationären Teil zugeordnet sein und wird nur in der Aufsetzposition des Bestückkopfes benötigt, um von Saugluft auf Blasluft umschalten zu können.

Dies wird z.B. durch Anspruch 2 dadurch erreicht, daß der Hauptkanal in einer Abluftöffnung endet, deren Strömungsquerschnitt durch eine veränderbare Drossel beeinflußt wird. Diese Beeinflussung kann so gesteuert werden, daß sich die Strömungsgeschwindigkeit im Hauptstromkanal verringert, wodurch das im Nebenstromkanal wirksame Vakuum aufgehoben oder je nach Drosselstellung in einen Überdruck umgewandelt werden kann.

Die blendenartige Drossel nach den Ansprüchen 3 und 4 kann über den vorbeigleitenden Abluftöffnungen angeordnet sein und durch Einschwenken gegen die Abluftströmung oder quer zu dieser betätigt werden, ohne daß es zu einer gegenseitigen Berührung kommt. Dies vereinfacht die mechanische Betätigung und Funktion der pneumatischen Vorgänge und kann ohne mechanischen Verschleiß vonstatten gehen.

Die Schallblende nach Anspruch 5 kann am stationären Teil derart angeordnet sein, daß sie sämtliche Abluftöffnungen der umlaufenden Sauggreifer in einem Abstand überdeckt, der die Strömung wenig behindert. Von Vorteil ist es dabei, den Ausströmkanal zur Austrittsöffnung trompetenartig zu erweitern, um eine möglichst widerstandsarme Strömung zu erreichen.

Durch die Weiterbildung nach Anspruch 6 können die Strahlpumpen in unmittelbarer Nähe der Sauggreifer angeordnet werden.

Durch die Zuordnung der Strahlpumpen zu den einzelnen Sauggreifern nach Anspruch 7 können die Saugleitungen weiter verkürzt werden.

Durch die Weiterbildung nach Anspruch 8 ist es möglich, die benötigten Drücke während des Aufsetzens regelbar zu steuern und unterschiedlichen Greifergrößen und Bauteilegrößen anzupassen.

Im folgenden wird die Erfindung anhand eines in der Zeichnung dargestellten Ausführungsbeispieles näher erläutert.
- Figur 1 und 2: zeigen in zwei Seitenansichten einen revolverartigen Bestückkopf mit einem stationären Teil und einem daran drehbar angetriebenen Drehkörper sowie mit Bauelementen und einer Leiterplatte,
- Figur 3 und 4: einen vergrößerten Ausschnitt aus Figur 1 in zwei verschiedenen Funktionsstellungen.

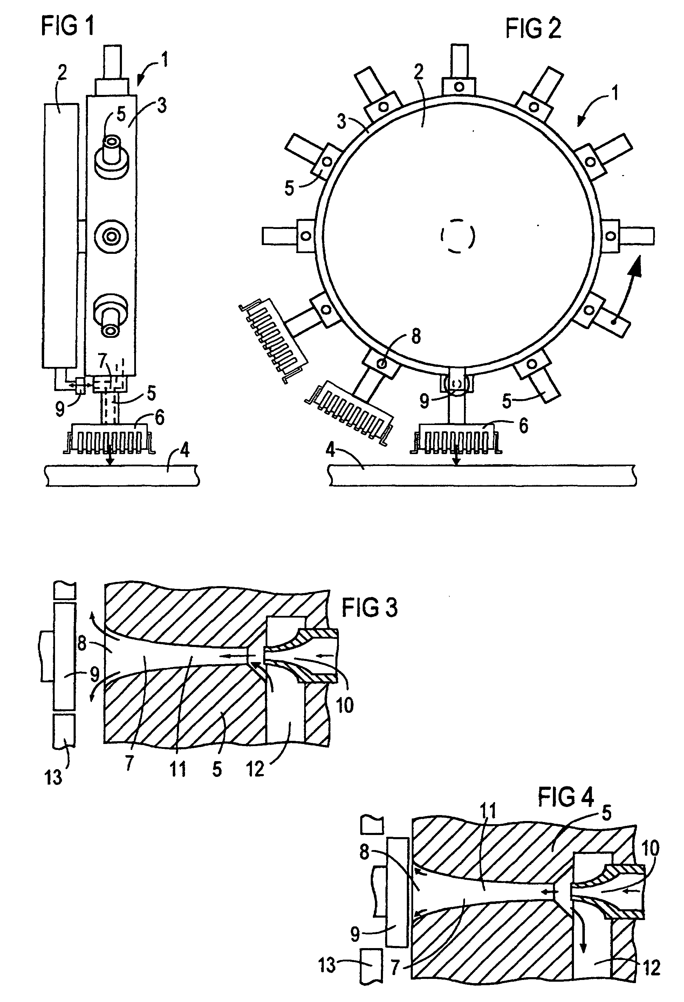

Nach den Figuren 1 und 2 besteht ein revolverartiger Bestückkopf 1 aus einem stationären Teil 2 und einem daran drehbar gelagerten und angetriebenen Drehkörper 3. Derartige Bestückköpfe sind z.B. in X-Y-Richtung über einem als Leiterplatte ausgebildeten Bauelementeträger 4 verfahrbar. Der Drehkörper 3 ist zirkulär mit sternförmig nach außen abstehenden Sauggreifern 5 versehen, die in einer schrittweisen Indexierung mit dem Drehkörper um dessen Mittelachse geschwenkt werden können.

An den Enden der Sauggreifer sind Saugöffnungen für angesaugte Bauelemente 6 vorgesehen. In jedem der einzelnen Sauggreifer 5 ist eine Strahlpumpe 7 angeordnet, die eine zum stationären Teil 2 hin weisende Abluftöffnung 8 aufweist.

Das unmittelbar über dem Bauelementeträger 4 befindliche Bauelement 6 ist an einem der Sauggreifer 5 gehalten, der sich gerade in der Aufsetzstellung befindet. Die diesem Greifer zugeordnete Abluftöffnung 8 weist in die Richtung des stationären Teils 2 und ist von einer Drossel 9 überdeckt, die am stationären Teil 2 angebracht ist. Diese Drossel 9 ist zur Abluftöffnung 8 hin bewegbar, wodurch die Strömungsverhältnisse in der Strahlpumpe 7 beeinflußt werden können.

In den Figuren 3 und 4 ist die Drossel 9 mit der Strahlpumpe 7 in zwei verschiedenen Stellungen gezeigt. Die Strahlpumpe 7 weist eine an eine Überdruckleitung angeschlossene Ausströmdüse 10 auf, die auf einen Hauptstromkanal 11 gerichtet ist, der in der Art einer Venturidüse ausgebildet ist. Im Übergangsbereich zwischen der Ausströmdüse 10 und dem Hauptstromkanal 11 ist ein Nebenstromkanal 12 senkrecht zum Hauptstromkanal 11 angesetzt. Dieser öffnet sich zur Abluftöffnung 8 hin trompetenartig.

In der in Figur 3 gezeigten Stellung befindet sich die Drossel 9 in einem Abstand zur Abluftöffnung 8, der einen Rückstau der ausströmenden Abluft weitgehend vermeidet. Im Bereich der Ausströmdüse 10 ist die Strömungsgeschwindigkeit so hoch, daß sich dort ein Unterdruck bildet. Dieser setzt sich im Nebenstromkanal 12 fort, der mit der Saugöffnung des Sauggreifers 5 verbunden ist. Der wirksame Unterdruck ist so groß, daß Bauelemente 6 an den Sauggreifern sicher gehalten werden.

In Figur 4 ist die blendenartige Drossel 9 in einer Schaltstellung gezeigt, in der der Abstand zur Abluftöffnung 8 erheblich verringert ist. Die Abluft kann nun nicht mehr frei ausströmen und wird im Hauptstromkanal 11 so stark zurückgestaut, daß im Nebenstromkanal ein Überdruck entsteht, der ein sicheres Ablösen des Bauelementes 6 (Figur 1) vom Sauggreifer 5 ermöglicht.

Seitlich der Drossel 9 ist eine als Prallblech ausgebildete Schallblende 13 angeordnet, die die unmittelbare Verwirbelung der ausströmenden Druckluft behindert und den entstehenden Schall dämpft. Die Schallblende 13 kann auch umlaufend über den Abluftöffnungen 8 der restlichen Sauggreifer 5 angebracht sein.

## Patentansprüche

1. Vorrichtung zum Bestücken von Bauelementeträgern (4) mit elektrischen Bauelementen (6) mittels eines revolverartigen Bestückkopfes (1) mit einem stationären Teil (2) und einem daran drehbar gelagerten Drehkörper (3), an dem eine Vielzahl von Sauggreifern (5) zirkulär angeordnet ist, die jeweils eine an eine Unterdruckquelle angeschlossene Öffnung zum Ansaugen der Bauelemente (6) aufweisen,
wobei der an der Öffnung wirksame Unterdruck nach dem Aufsetzen der Bauelemente (6) auf dem Bauelementeträger (4) zumindest kurzzeitig, abschaltbar oder umkehrbar ist und
wobei der Unterdruck mittels zumindest einer mitdrehenden Strahlpumpe (7) erzeugbar ist, die einen ins Freie führenden Hauptstromkanal (11) und einen seitlich abzweigenden Nebenstromkanal (12) aufweist, an dem sich ein Unterdruck bildet und der mit der Saugöffnung des Sauggreifers (5) verbunden ist,
**dadurch gekennzeichnet,**
**daß** für jeden der Sauggreifer (5) je eine Strahlpumpe (7) mit je einem Hauptstromkanal (11) und je einem Nebenstromkanal (12) vorgesehen ist,
**daß** die Druckverhältnisse des Nebenstromkanals (12) durch Beeinflussung der Strömung des Hauptstromkanals (11) veränderbar sind und
**daß** der stationäre Teil (2) des Bestückkopfes (1) Beeinflussungsmittel für die Strahlpumpe des jeweils in der Aufsetzposition befindlichen Sauggreifers (5) aufweist.

2. Vorrichtung nach Anspruch 1,
**dadurch gekennzeichnet,**
**daß** der Hauptstromkanal (12) in einer Abluftöffnung (8) endet, daß die Beeinflussungsmittel als veränderbare Drossel (9) ausgebildet sind, die den Strömungsquerschnitt der Abluftöffnung (8) verändert.

3. Vorrichtung nach Anspruch 2,
**dadurch gekennzeichnet,**
**daß** die blendenartige Drossel (9) vor die Abluftöffnung (8) bewegbar ist.

4. Vorrichtung nach Anspruch 3,
**dadurch gekennzeichnet,**
**daß** die Drossel (9) gegen die oder quer zur Ausströmrichtung zur Abluftöffnung (8) hin verschiebbar ist.

5. Vorrichtung nach einem der vorhergehenden Ansprüche,
**dadurch gekennzeichnet,**
**daß** im Bereich der Abluftöffnungen eine Schallblende (13) vorgesehen ist.

6. Vorrichtung nach einem der vorhergehenden Ansprüche,
**dadurch gekennzeichnet,**
**daß** die Strahlpumpen im Drehkörper des Bestückkopfes angeordnet sind und
**daß** die Nebenstromkanäle über entsprechende Leitungen mit den Sauggreifern verbunden sind.

7. Vorrichtung nach einem der vorhergehenden Ansprüche,
**dadurch gekennzeichnet,**
**daß** die Strahlpumpen (7) den einzelnen Sauggreifern (5) in der Nähe der Saugöffnungen zugeordnet sind.

8. Vorrichtung nach einem der vorhergehenden Ansprüche,
**dadurch gekennzeichnet,**
**daß** in der Nähe der Saugöffnung ein schnell reagierender Sensor vorgesehen ist, ,
**daß** die Drosselposition mittels eines steuerbaren Antriebes veränderbar ist und
**daß** der Antrieb und der Drucksensor mit einem Steuerwerk verbunden sind, das Meßsignale des Drucksensors auswertet und das in Abhängigkeit von diesem die Drosselposition verändert.

## Claims

1. Device for mounting electrical components (6) onto component carriers (4) by means of a revolver-like placement head (1) comprising a stationary part (2) and a rotary body (3) rotationally mounted thereon, around which rotary body a plurality of vacuum suction grippers (5) are disposed in a circular arrangement, each of which has an aperture connected to a negative pressure source and intended for holding the components (6) by vacuum suction,
wherein the negative pressure acting at the aperture can be at least briefly switched off or reversed after the mounting of the components (6) on the component carrier (4) and
wherein the negative pressure can be generated by means of at least one co-rotating air injection pump (7) which has a main flow channel (11) leading into the open air and a laterally branching-off secondary flow channel (12) at which a negative pressure forms and which is connected to the suction aperture of the vacuum suction gripper (5),
**characterised in that**
one air injection pump (7) each having one main flow channel (11) and one secondary flow channel (12) is provided for each of the vacuum suction grippers (5),
the pressure conditions in the secondary flow channel (12) can be modified by varying the flow rate of the main flow channel (11) and
the stationary part (2) of the placement head (1) has influencing means for the air injection pump of the vacuum suction gripper (5) located in the mounting position at a given time.

2. Device according to claim 1,
**characterised in that**
the main flow channel (12) ends in an exit air aperture (8), and the influencing means are embodied as a variable choke (9) which varies the flow cross-section of the exit air aperture (8).

3. Device according to claim 2,
**characterised in that**
the diaphragm-like choke (9) is movable in front of the exit air aperture (8).

4. Device according to claim 3,
**characterised in that**
the choke (9) is displaceable against or at right angles to the discharge direction towards the exit air aperture (8).

5. Device according to one of the preceding claims,
**characterised in that**
a sound gobo (13) is provided in the area of the exit air apertures.

6. Device according to one of the preceding claims,
**characterised in that**
the air injection pumps are disposed in the rotary body of the placement head and
the secondary flow channels are connected to the vacuum suction grippers via corresponding lines.

7. Device according to one of the preceding claims,
**characterised in that**
the air injection pumps (7) are assigned to the individual vacuum suction grippers (5) in the vicinity of the suction apertures.

8. Device according to one of the preceding claims,
**characterised in that**
a fast reacting sensor is provided in the vicinity of the suction aperture,
the choke position can be varied by means of a controllable drive and
the drive and the pressure sensor are connected to a control unit which interprets measurement signals of the pressure sensor and varies the choke position as a function thereof.

## Revendications

1. Dispositif de montage de composants électriques (6) sur des supports (4) de composants au moyen d'une tête de montage (1) de type revolver qui présente une partie stationnaire (2) et un corps rotatif (3) qui y est monté à rotation et sur lequel plusieurs dispositifs (5) de saisie par aspiration qui présentent chacun une ouverture d'aspiration des composants (6) qui est raccordée à une source de dépression sont disposés en cercle,
la dépression qui agit sur l'ouverture pouvant être au moins brièvement débranchée ou inversée après la pose des composants (6) sur le support (4) de composants, la dépression pouvant être créée au moyen d'au moins une pompe à jet (7) qui tourne conjointement et qui présente un canal d'écoulement principal (11) qui conduit à l'air libre et un canal d'écoulement secondaire (12) qui en est dérivé latéralement, sur lequel se forme une dépression et qui est relié à l'ouverture d'aspiration du dispositif (5) de saisie par aspiration,
**caractérisé en ce que**
une pompe à jet (7) qui présente un canal d'écoulement principal (11) et un canal d'écoulement secondaire (12) est prévue pour chacun des dispositifs (5) de saisie par aspiration,
**en ce que** les conditions de pression dans le canal d'écoulement secondaire (12) peuvent être modifiées par action sur l'écoulement dans le canal d'écoulement principal (11) et
**en ce que** la partie stationnaire (2) de la tête de montage (1) présente des moyens d'action sur la pompe à jet du dispositif (5) de saisie par aspiration qui est respectivement situé en position de pose.

2. Dispositif selon la revendication 1, **caractérisé en ce que** le canal d'écoulement principal (12) se termine en une ouverture (8) d'évacuation d'air et **en ce que** les moyens d'action sont configurés comme étrangleurs (9) modifiables qui modifient la section transversale d'écoulement de l'ouverture (8) d'évacuation d'air.

3. Dispositif selon la revendication 2, **caractérisé en ce que** l'étrangleur (9) en forme d'écran peut être déplacé devant l'ouverture (8) d'évacuation d'air.

4. Dispositif selon la revendication 3, **caractérisé en ce que** l'étrangleur (9) peut être déplacé contre ou transversalement par rapport à la direction de sortie vers l'ouverture (8) d'évacuation d'air.

5. Dispositif selon l'une des revendications précédentes, **caractérisé en ce qu'**un écran acoustique (13) est prévu dans la zone des ouvertures d'évacuation d'air.

6. Dispositif selon l'une des revendications précédentes, **caractérisé en ce que** les pompes à jet sont disposées dans le corps rotatif de la tête de montage et **en ce que** les canaux d'écoulement secondaire sont reliés au dispositif de saisie par aspiration par des conduits appropriés.

7. Dispositif selon l'une des revendications précédentes, **caractérisé en ce que** les pompes à jet (7) sont associées aux dispositifs (5) de saisie par aspiration individuels à proximité des ouvertures d'aspiration.

8. Dispositif selon l'une des revendications précédentes, **caractérisé en ce qu'**un capteur à réaction rapide est prévu à proximité de l'ouverture d'aspiration,
**en ce que** la position de l'étrangleur peut être modifiée au moyen d'un entraînement commandable et
**en ce que** l'entraînement et le capteur de pression sont reliés à un mécanisme de commande qui évalue les signaux de mesure du capteur de pression et qui modifie la position de l'étrangleur en fonction de ces signaux.
